Europäisches Patentamt

European Patent Office

Office européen des brevets

(19)

(11) **EP 1 215 822 A1**

(12) **EUROPEAN PATENT APPLICATION**

(43) Date of publication:
**19.06.2002  Bulletin 2002/25**

(51) Int Cl.⁷: **H04B 1/40**, H04L 27/16,
H03J 7/06, H04B 17/00

(21) Application number: **00127720.1**

(22) Date of filing: **18.12.2000**

| (84) Designated Contracting States:<br>**AT BE CH CY DE DK ES FI FR GB GR IE IT LI LU MC NL PT SE TR**<br>Designated Extension States:<br>**AL LT LV MK RO SI**<br><br>(71) Applicant: **Nokia Corporation**<br>**02150 Espoo (FI)** | (72) Inventor: **Burgess, Paul**<br>**44809 Bochum (DE)**<br><br>(74) Representative: **Becker Kurig Straus**<br>**Patentanwälte**<br>**Bavariastrasse 7**<br>**80336 München (DE)** |

(54) **Radio transmission device and method for aligning parameters thereof**

(57)    The application discloses a radio transmission device (1) for receiving/transmitting of radio packets, comprising a reception means (34) arranged to receive radio signals, a phase locked loop (14) designed to be locked to a multiple of a reference oscillator (8) frequency, a mixing means (4) having its inputs connected to said reception means (34) and said phase locked loop (14), an intermediate frequency filtering means (6) having its input connected to the output of said mixing means (4), a demodulation means (12) connected to the output of the intermediate frequency filtering means (6) and a base band processing means (20) connected to the output of the demodulation means (12). A branch off line is connected between the reference oscillator (8) and the phase locked loop (14), a frequency dividing means (10), releaseably connected to said branch off line to divide the reference frequency of said reference oscillator (8), the output of said frequency dividing means (10) being connected with the input of said intermediate frequency filtering means (6) and said base band processing means (20) being connected to said reference oscillator (8).

Fig. 4

**Description**

The present invention relates generally to radio transceivers using phase-locked loop circuits (PLLs). It also relates generally to superheterodyne radio transceivers. In particular the present invention relates to superheterodyne transceivers capable of executing an alignment process without using an external feedback loop.

The growing spread of cellular phones in recent years shows the demand for low cost transceivers. As for the phones, a wireless transmission system is planned to replace connection wires in other technical fields.

One conventional system to replace connection wires is the Bluetooth™ system. It is a low power, low range, and low cost radio communication system that is planned to replace wires or cables between computers, components, e.g. monitors and the like. The Bluetooth™ system operates at a frequency of 2.4 GHz. The frequency band is called ISM (Industrial Scientific and Medicine) and is destined for unlicensed low power radio operation up to a maximum irradiated power up to 100 mW, or 20 dbm. With an irradiated power up to 100 mW a spatial transmission range of a few centimetres up to a few hundred meters can be attained. Due to limitations in different countries, 23 to 79 channels having a bandwidth of 1 MHz are allocated for the unlicensed use. The Bluetooth™ system uses a frequency hopping algorithm to reduce interference caused by other users of the ISM band. The frequency hopping is executed at a rate of 1600 hops per second.

With such a short distance radio transmission all plug-in connection problems associated with e.g. laptop computers having periphery devices such as printers, storage means, or a network are easily solved, thereby obviating the need for a wire connection.

In most transceivers having variable frequency a phase locked loop (PLL) circuit is used to generate the channel frequency. The use of a PLL is a well known and cheap way to build a variable frequency generator having almost the frequency stability of a quartz oscillator.

A standard PLL comprises a voltage controlled oscillator (VCO), a frequency divider, a reference oscillator and a feed back loop. In the standard operation, the output oscillation from the VCO is divided by a frequency divider and the phases are compared with the phases of a reference oscillator in a phase detector. Any deviation of the phases of the divided VCO frequency and the reference oscillation is fed back to the VCO. With this feedback loop the output frequency of the PLL is locked to a multiple of the reference oscillator frequency. Frequency deviations of the reference oscillator due to manufacturing tolerances are multiplied by the division factor of the frequency divider. Therefore it is important to align the reference oscillator.

For low cost radio transceivers the frequency of the reference oscillator is usually adjusted during manufacture using a piece of measurement equipment such as a frequency counter. The frequency is measured while at the same time an internal parameter of the transceiver is varied until the measured frequency reaches the required value. The accuracy of the final frequency is therefore related to the time necessary for the adjustment process and the cost incurred by the final measurement equipment used. This method is used for Bluetooth™ modules during production.

Frequency shift keying (FSK) transceivers e.g. frequency modulation (FM) transceivers must have their modulation index of the transmitting path of the transceiver aligned. It is usual routine to align the modulation index of a FSK transceiver such that the frequency deviation fulfils a given specification. For example, the specification requires that the maximum and minimum frequency deviations are not allowed to exceed predetermined limits. To achieve this accuracy the transmitter modulation index must be aligned by adjusting the transmitter of the device under test (DUT). The time taken for this alignment and the cost of the equipment required must be related to the accuracy of the final result.

The alignment which is eventually adopted uses a spectrum analyzer to measure the output spectrum of the generated signal from the DUT transmitter. This result is employed to calculate the correct setting for the transmitter. The final setting is fed back to the DUT and a further measurement is made to confirm the setting.

The main drawback of the conventional alignment processes resides in the expensive test equipment and a time consuming alignment process. The alignment processes require complex algorithms and external feedback loops. Therefore, a transceiver module that can be sold to customers for integration into e.g. personal computers, has to provide additional external outputs and inputs. A conventional radio frequency transceiver module in addition needs a base band memory capacity.

From the WO 00/18072 there are already known receivers and transmitters for receiving or transmitting a radio packet at a predetermined frequency. A transceiver according to this document permits a power saving operation. It is not capable though of executing fast and simple alignment processes for the operation parameters, such as the reference oscillator frequency or the transmit modulation index.

The object underlying the invention is to provide a method and an apparatus capable of executing a fast and simple alignment process, without using any external feedback loops.

A further object of the invention is to increase the capacity of the manufacturing process by simplifying the alignment process leading to shorter cycle times.

A further object of the invention is to enable a customer to integrate a radio module in an application, even under job lot production conditions, without the need for expensive test equipment.

According to one aspect of the invention, this is achieved by a radio transmission device for receiving/transmitting of radio packets, capable for executing a fast and simple process for alignment of its parameters. Such a radio transmission device comprises a reception means arranged to receive radio signals, a phase locked loop circuit designed to be locked to a multiple of a reference oscillator frequency. It also comprises a mixing means having its inputs connected to said reception means and said phase locked loop circuit, and an intermediate frequency filtering means having its input connected to the output of said mixing means. The radio transmission device comprises a demodulation means connected to the output of the intermediate frequency filtering means and a base band processing means connected to the output of the demodulation means, too. The radio transmission device is characterised by a branch off line connected between the reference oscillator and the phase locked loop, a frequency dividing means, releaseably connected to said branch off line in order to divide the reference frequency of said reference oscillator, the output of said frequency dividing means being connected with the input of said intermediate frequency filtering means. The radio transmission device is also characterised in that said base band processing means is connected to said reference oscillator, to align the frequency of the reference oscillator. The radio transmission device can be a receiver, a transceiver, or a receiver or transceiver module.

In such a radio transmission device a reference oscillator alignment can be executed. The alignment process can be executed by using a calibrated reference frequency generator emitting a fixed continuous wave signal.

According to another aspect of the invention, the radio transmission device for receiving/transmitting of radio packets, comprises a reception means connected to a mixing means via a transmit/receive switch and an amplifying means. It also comprises a mixing means being connected via a demodulation means to a base band processing means, wherein said base band processing means is connected via a modulation means to a power amplifying means. The radio transmission device is characterised in that said modulation means is releasably connected via a phase locked loop circuit to said mixing means.

By using such a radio transmission device a modulation index alignment can be performed. The alignment process can be executed by using a calibrated reference frequency generator emitting a fixed continuous wave signal and a fixed modulated continuous wave signal.

Preferably the radio transmission device, further comprises a phase locked loop designed to be locked to a multiple of a reference oscillator frequency, a mixing means having its inputs connected to said amplifying means and said phase locked loop. It also comprises an intermediate frequency filtering means which is operatively inserted between said mixing means and said demodulation means. The radio transmission device also comprises a branch off line connected between the reference oscillator and the phase locked loop, and a frequency dividing means releasably connected to said branch off line to divide the reference frequency of said reference oscillator. The radio transmission device is designed such that the output of said frequency dividing means is connected with the input of said intermediate frequency filtering means, and said base band processing means is connected to said reference oscillator.

By using such a radio transmission device both a reference oscillator alignment and a modulation index alignment can be executed successively. Both alignment processes can be executed with the same calibrated reference frequency generator using the same fixed continuous wave signal.

Conveniently the output of said frequency dividing means is connected with the input of said demodulation means.

By bypassing the intermediate frequency filter the design of the radio transmission device can be simplified.

Preferably the base band processing means comprises analog/digital converting means.

By using analog/digital converting means, detected demodulated signals are simpler to be saved and to be compared.

Conveniently the radio transmission device comprises an auxiliary amplifying means operationally inserted between the demodulation means and the base band processing means.

By inserting an auxiliary amplifying means between the demodulation means and the base band processing means, the sensitivity of the detection is increased.

Advantageously the transmitter further comprises a pre-calibrated reference oscillator.

By having a pre-calibrated reference oscillator, the radio transmission device is capable of re-aligning its reference oscillator and its modulation index at any time. This is interesting e.g. for radio transmission devices using more than one reference oscillator.

According to another aspect of the invention, the problem is solved by a radio network having radio transmission devices according to the invention.

According to yet a further aspect of the invention there is provided a method for aligning parameters in a radio transmission device by supplying a fixed continuous wave signal to said radio transmission device, initiating a fast and simple alignment process in said radio transmission device in accordance with said continuous wave signal and terminating the fast and simple alignment process. The fixed continuous wave signal can be a sinus signal.

By supplying a fixed continuous wave signal instead of a complex test equipment, the alignment time and the

EP 1 215 822 A1

financial expenditure can be decreased significantly. A customer using this fast and simple alignment process is capable of executing an alignment process without specific radio frequency experience.

Preferably the alignment process further comprises the following steps:

- Inhibiting the phase locked loop signal;
- Dividing the reference oscillator signal of the reference oscillator of said radio transmission device;
- Demodulating said divided reference oscillator signal;
- Detecting said demodulated divided reference oscillator signal;
- Saving said detected demodulated divided reference oscillator signal;
- Inhibiting said divided reference oscillator signal;
- Terminating the inhibition of said phase locked loop signal;
- Mixing the phase locked loop signal with said fixed continuous wave signal;
- Filtering said mixed signal;
- Demodulating said filtered mixed signal;
- Detecting said demodulated filtered mixed signal;
- Comparing said demodulated filtered mixed signal with said saved demodulated divided reference oscillator signal;
- Varying a reference oscillator parameter until said demodulated filtered mixed signal equals said demodulated divided reference oscillator signal.

By inhibiting the phase locked loop signal in the receiving path of the radio transmission device, internal interference during the alignment process is avoided. By dividing the reference oscillator signal the deviation of the frequency is divided too. By demodulating, the signal is transformed into a DC voltage. The DC voltage signal is detected and saved. By inhibiting the divided reference oscillator signal, internal interference is avoided. By terminating the inhibition of the PLL signal, the PLL signal can be mixed with the supplied fixed continuous wave signal. The mixed signal is filtered, demodulated, detected and compared to the saved DC voltage signal. Thereafter, a reference oscillator parameter is varied until said demodulated mixed signal equals the saved DC voltage.

Conveniently the alignment process further comprises the step of digitising demodulated signals.

By digitising the demodulated signals, the signals can be stored, be compared and be processed.

Preferably the divided reference oscillator signal is filtered.

By filtering the divided signal of the reference oscillator, interference can be avoided.

Advantageously the signals are amplified between the demodulating and detecting of the signal.

By amplifying the signals in between the sensibility of the detection is increased.

Conveniently the alignment process further comprises the following steps of:

- Applying a fixed modulated continuous wave signal;
- Amplifying said fixed modulated continuous wave signal;
- Mixing said fixed modulated continuous wave signal with said local oscillator signal;
- Demodulating said first mixed signal;
- Detecting said first demodulated signal;
- Saving said first detected signal;
- Applying said fixed continuous wave signal;
- Amplifying said fixed continuous wave signal;
- Recalling said saved signal;
- Modulating said signal;
- Mixing said fixed continuous wave signal with said modulated signal;
- Demodulating said second mixed signal;
- Comparing said saved signal with said second demodulated mixed signal;
- Varying a modulation means parameter until said second demodulated mixed signal equals said saved signal.

By amplifying said fixed continuous wave or modulated continuous wave signal, the input amplitude of the mixing device can be controlled. By mixing and demodulating the modulated continuous wave signal, the base band processing means detects a first signal. This first signal is related to the modulated continuous wave signal of the calibrated reference frequency generator 2 and to the transmission function of the receiving path. This signal is saved in the base band processing means. By recalling the saved signal and modulating said recalled signal in the transmitting path of the radio transmission device, a signal related to the modulation index of the modulation means is generated. By mixing the continuous wave signal with the modulated signal, a modulated intermediate frequency signal is generated, which is also related to the transmit modulation index. Demodulating of this intermediate frequency signal generates a signal which is related to the transmit modulation index and to the transmission function of the receiving path.

By comparing the fed back signals with the stored signal the transmission function of the receiving path can be compensated. The modulation index can be varied until both signals are equal. With indistinguishable or noisy signals, the modulation index is aligned and the alignment process can be terminated.

Preferably the alignment process further comprises at least one of the following steps of:

- Initiating a second alignment process in the radio transmission device;
- Repeating the alignment process.

By initiating a second alignment process the modulation index can be aligned, too. By repeating the alignment process, the accuracy of the reference oscillator alignment may be increased.

Further advantages, advantageous embodiments and additional applications of the invention are provided in the following description of a preferred embodiment of the invention in connection with the enclosed figures.

Fig. 1    is a block diagram of a conventional reference oscillator alignment process.

Fig. 2    is a block diagram of a conventional modulation index alignment process.

Fig. 3    is a block diagram of an alignment process according to the invention.

Fig. 4    is a block diagram of a first step of a reference oscillator alignment process.

Fig. 5    is a block diagram of a second step of a reference oscillator alignment process.

Fig. 6    is a block diagram of a first step of a modulation index alignment process.

Fig. 7    is a block diagram of a second step of a modulation index alignment process.

Fig. 8    is a block diagram of a radio transmission device network according to the invention.

While the following description is in the context of wireless communication systems involving portable or mobile radio telephones and/or computer communication systems, it will be understood by those skilled in the art that the present invention may be applied to other oscillating devices. Moreover, the present invention may be used in any device as a variable oscillator, such as computers etc.

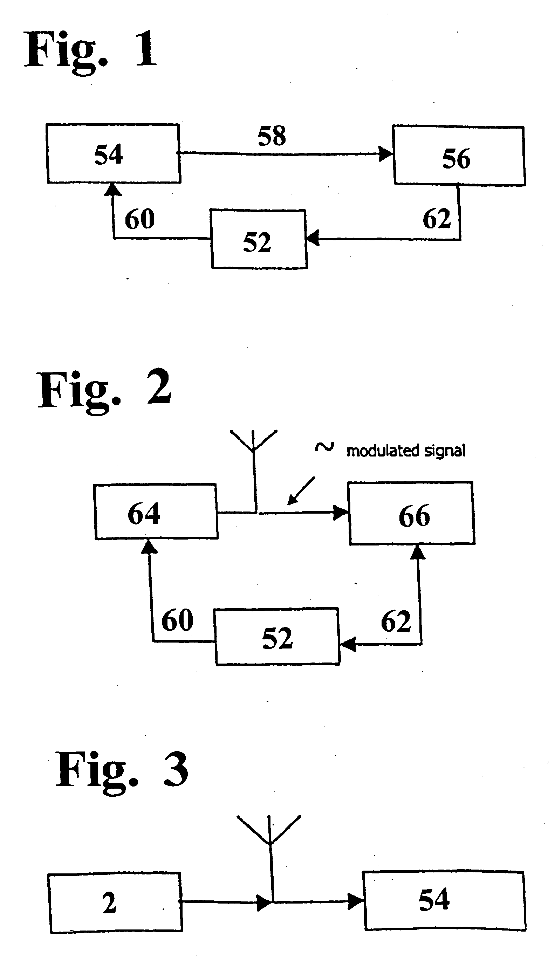

Fig. 1 is a block diagram of a conventional reference oscillator alignment. In a radio transmission device 54 the frequency of the reference oscillator is usually adjusted during production by using a piece of measurement equipment such as a frequency counter 56. A reference frequency oscillator (not shown) of the transmitter 54 is connected via a radio frequency connection 58 to said frequency counter 56. The frequency is detected in said frequency counter 56. The detected value is transferred via bus 62 to a control unit 52. The control unit 52 varies, via a control bus 60, an internal parameter of the radio transmission device 54 at the same time, until the detected frequency matches the required value. The accuracy of the final frequency is therefore related to the time taken for this adjustment and the cost of the measurement equipment used. This method typically takes a time of 5 seconds for an accuracy of $\pm$ 2ppm.

Fig 2 is a block diagram of a conventional transmitter modulation index alignment. The alignment which is conventionally performed uses a spectrum analyzer 66 to analyze the output spectrum of a signal generated by a DUT (device under test) 64 transmitter. The DUT 64 is connected to the spectrum analyzer 66 via a radio frequency connection. The detected values are transferred via bus 62 to a control unit 52. The control unit 52 uses the received data to calculate the correct setting of the transmitter. The final setting is fed back to the DUT via a control bus 60. A further measurement is made to confirm the setting. The spectrum analyzer 66 must be tuned to the correct detection mode such that the measurement can be performed. This is usually controlled by an external control unit 52.

Fig. 3 is a block diagram of an alignment process according to the invention. A calibrated reference frequency generator 2 is connected to the DUT 54. The steps included in a reference oscillator alignment process and in a transmitter modulation index alignment process are the same. The same calibrated reference frequency generator 2 is used. The calibrated reference frequency generator 2 transmits a continuous wave (CW) signal to the DUT 54. There is no external feedback loop necessary.

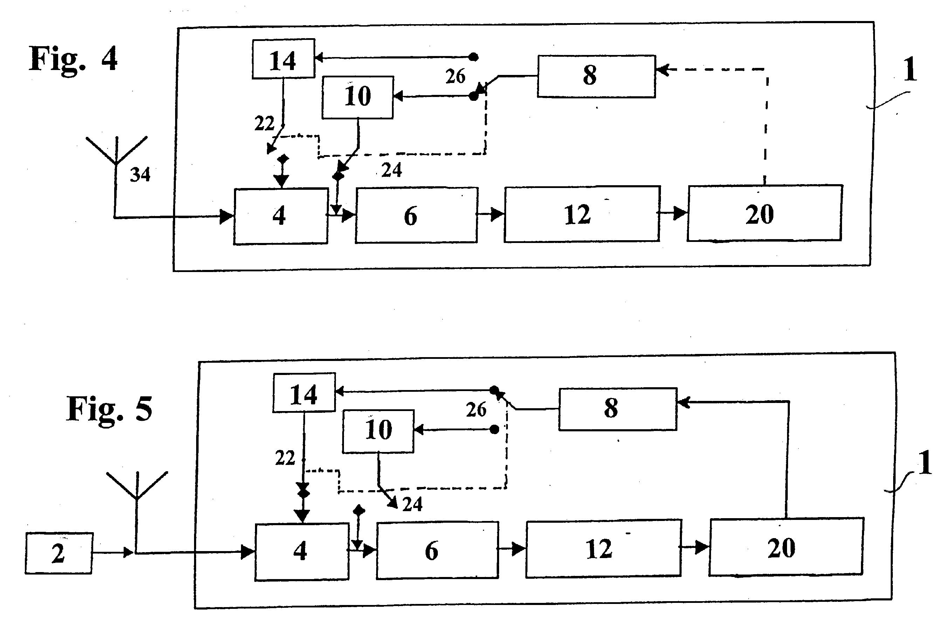

Fig. 4 is a block diagram of a radio transmission device 1 for the execution of a fast and simple reference oscillator alignment process in accordance with the invention. The radio transmission device is a superheterodyne receiver in the first stage of a fast and simple alignment process. The receiver comprises a phase locked loop (PLL) 14 connected to a reference oscillator 8. The PLL 14 can be connected via a switch 22 to a mixing means 4. The mixing means 4 is connected to a reception means and to an intermediate frequency filtering means 6. The intermediate frequency filtering means 6 is connected via a demodulation means 12 to a base band processing means 20. The receiver 1 further comprises a selective switch 26 to connect the PLL 14 and the reference oscillator 8. It further comprises switches 24, 26, capable of switching in a frequency dividing means 10 between the reference frequency oscillator 8 and the intermediate frequency filtering means 6. With the switch positions as shown, the frequency of the reference frequency oscillator 8 is divided by the frequency dividing means 10 and fed via the intermediate frequency filtering means 6 to the demodulation means 12. The frequency dividing means 10 has such a division ratio (R), that the divided reference frequency equals the intermediate frequency (IF). The demodulation means 12 transforms the IF signal into a DC voltage signal which is detected by the base band processing means 20. The first dashed line, connecting the base band processing means 20 with the reference oscillator 8, is inactive during this phase of the fast and simple reference oscillator alignment. The second dashed line operatively connects the switches 22, 24, 26.

In this first phase the unaligned reference oscillator is oscillating at a frequency different from the ideal oscillator frequency $F_{osc}$. The difference of the frequency of the unaligned oscillator to the ideal frequency is the deviation frequency $F_{error}$. With R being the division ratio of the frequency dividing means 10 and K being the demodulator constant in units of $^{mv}/_{mhz}$, the voltage at the output of the demodulation means 12 will be:

$$V_1 = K \cdot R \cdot (F_{osc} + F_{error})$$

Fig. 5 is a block diagram of the superheterodyne receiver of Fig. 4 in the second stage of the fast and simple alignment process. With the switch positions as shown, the frequency of the reference frequency oscillator 8 is used to lock the frequency of the PLL 14 to a multiple of the reference oscillator frequency. A multiple of the frequency is equal to the division factor (N) of a frequency dividing means (not shown) within the PLL. The multiple of the oscillator frequency ($F_{osc} + F_{error}$) is fed to the mixing means 4. At the second input a test frequency $F_{test}$ from an external calibrated reference frequency generator 2 is fed to the mixing means 4. The output frequencies of the mixing means 4 are $[F_{test} - N \cdot (F_{osc} + F_{error})]$ and $[F_{test} + N \cdot (F_{osc} + F_{error})]$. Both frequencies are fed to the IF filtering means 6. Only the frequency $[F_{test} - N \cdot (F_{osc} + F_{error})]$ can pass the IF filtering means 6. The demodulation means 12 transforms the IF signal into a DC voltage signal which is detected by the base band processing means 20. With N being the division ratio of the frequency dividing means within the PLL and K the demodulator constant in units of $^{mv}/_{mhz}$, the voltage at the output of the demodulation means will be:

$$V_2 = K \cdot [F_{test} - N \cdot (F_{osc} + F_{error})]$$

The difference between the voltages $V_1$ and $V_2$ resulting from the first and second alignment stages can therefore be expressed as:

$$\Delta V = V_1 - V_2 = K \cdot [R \cdot (F_{osc} + F_{error}) - F_{test} - N \cdot (F_{osc} + F_{error})]$$

Since $R \cdot F_{osc} = F_{test} - N \cdot F_{osc}$ the difference voltage is therefore:

$$\Delta V = K \cdot (R \cdot F_{error} - N \cdot F_{error}) = K \cdot F_{error} (R - N)$$

It can therefore be seen that, if N>>R, the difference voltage is proportional to $K \cdot N \cdot F_{error}$. For a given 2.4 GHz superheterodyne receiver with an IF of 1 MHz and a reference frequency of 13 MHz, R = $^1/_{13}$, and N = $2.3 \cdot 10^9/13 \cdot 10^6$ ≈177 therefore the error voltage is proportional to N alone. The second stage of the alignment for this receiver uses an externally generated test signal at around 2.4 GHz, corresponding to one of the ISM-channels.

An analog/digital converter (not shown) in the base band processing means 20 detects the difference between these two resulting voltages and the oscillator frequency will be adjusted in order to minimize this difference voltage and therefore achieve the required frequency accuracy.

Furthermore the gain of the demodulation means is increased during this alignment using an auxiliary amplifying means (not shown) between the demodulation means and the analog/digital converter. This auxiliary amplifying means has the effect of improving the accuracy of the fast and simple alignment. Furthermore the accuracy of the fast and simple alignment can be improved by repeating the procedure.

The proposed solution distinguishes over conventional alignment processes in that no expensive test equipment is required as a simple signal source can be used. This is very attractive to customers having little experience in radio frequency equipment such as computer or camera manufacturers. Other advantages reside in that the alignment time is much quicker since measurement performed by external test equipment is obviated and the alignment is much simpler to be implemented by the application engineer since no external feedback loop is required to feed the measurement result back to the radio transmission device. Moreover no reference oscillator output has to be provided for measurement during production and no base band memory is required and therefore an RF-only solution without memory storage incorporating the invention could be sold to external customers.

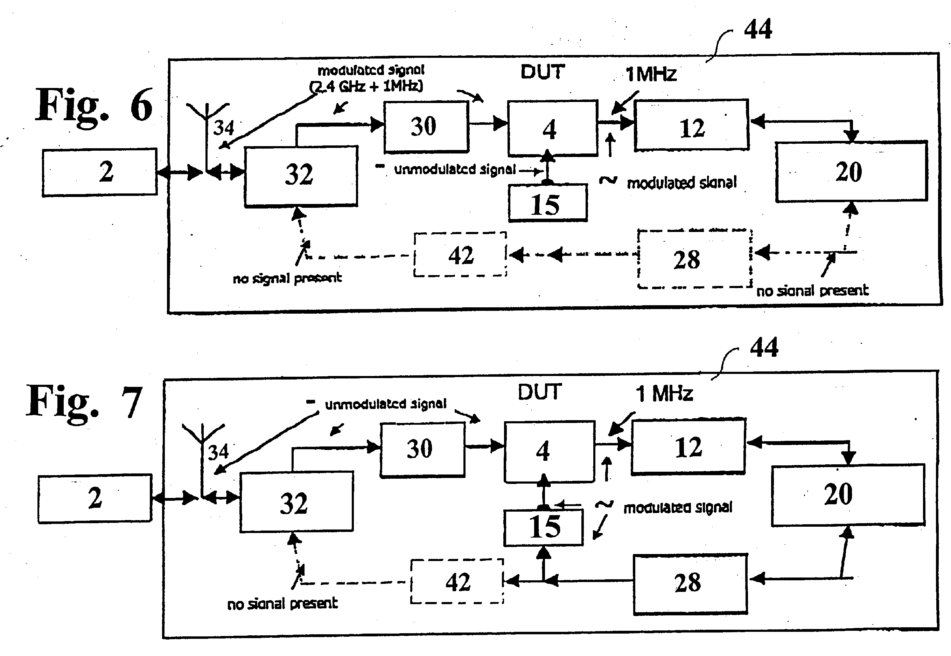

Fig. 6 is a block diagram of a radio transmission device 44 for the execution of a fast and simple transmit modulation index alignment process. The radio transmission device 44 represents the first stage of a fast and simple transmit modulation index alignment process. The radio transmission device comprises a receiving part having a reception means 34, a transmit/receive- (TX/RX-) switch 32, an amplifying means 30, a mixing means 4 usually connected to a phase locked loop circuit 15, a demodulation means 12 and a base band processing means 20. The demodulation means 12 has the ability to determine the amplitude of the incoming signal. The radio transmission device also comprises a transmitting part comprising said base band signal processing means 20, a modulation means 28 connected via a power amplifying means 42 and the TX/RX-switch 32 to the reception means 34.

In the first stage, the TX/RX- switch 32 is switched to the RX position, wherein both the power amplifying means 42 and the modulation means 28 shown in dashed lines are inactive during this first step of the fast and simple modulation index alignment. At the reception means 34 a modulated continuous wave signal is received from an external calibrated reference frequency generator 2. This signal can be for example a 2.4 GHz signal modulated with a 1 MHz signal. The signal is fed via the amplifying means 30 to the mixing means 4. At the mixing means 4 the modulated signal is mixed with an unmodulated signal from the phase locked loop circuit 15. The mixed signal is demodulated by the demodulation means 12. The demodulated mixed signal is detected and saved by the base band processing means 20.

Fig. 7 is a block diagram of a radio transmission device 44 of Fig.6 in the second stage of the fast and simple transmit modulation index alignment process. In the second stage of the alignment process, the displayed solution allows both, the receiver and transmitter to be operated simultaneously while at the same time the internal phase locked loop circuit 15 signal is modulated by the transmitter. The TX/RX- switch 32 is switched to the RX position and the power amplifying means 42 shown in dashed lines is inactive during the second stage of the fast and simple modulation index alignment. At the reception means 34 an unmodulated continuous wave signal is received from an external calibrated reference frequency generator 2. The signal is fed via the amplifying means 30 to the mixing means 4. Under the control of the base band processing means 20 said internal phase locked loop circuit 15 local oscillator signal is modulated by the modulation means 28. Said modulated local oscillator signal is fed to the mixing means 4. As a result of the two input signals a mixed signal is generated and fed to the demodulation means 12. The demodulated mixed signal is detected by the base band processing means 20, and is compared to the signal saved during the first stage of the alignment process. The modulation index of the transmitter can therefore be measured by the base band processing means 20 and be adjusted until the demodulated mixed signal is substantially similar to the previously saved signal.

One advantage of the proposed solution over conventional alignment processes is, that no expensive test equipment is required since a simple signal source can be used. This is very attractive to customers with little experience in radio frequency equipment such as computer or camera manufacturers. Other advantages are that the alignment time is much quicker since no measurement is performed by external test equipment and the alignment is much simpler to be implemented by the application projects since no external feedback loop is required to feed the measurement result back to the radio transmission device. Lastly, no base band memory is required and therefore a RF-only solution without memory storage can be sold to external customers.

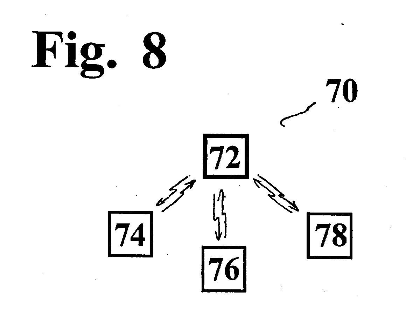

Fig. 8 illustrates a radio network 70 of radio transmission device units according to the invention, including a master radio transmission device 72 and slave radio transmission devices 74, 76 and 78 communicating by transmitting and receiving radio packets. The master radio transmission device 72 initiates the connection of a slave to the network. The network operates in a time division duplex fashion. The radio transmission device units are synchronised to a common time frame determined by the master radio transmission device 72. To prevent interference the time division duplex transmission is combined with a frequency hopping algorithm. The radio transmission device units are synchronised to the frequency hopping algorithm by the master radio transmission device 72. The master radio transmission device 72 is capable of performing point-to-point or point-to-multi-point communication. The slave radio transmission devices 74, 76, 78 are only capable of replying to an order from the master radio transmission device 74. In this network 70 the master radio transmission device 72 is capable of dispatching an order to the slave radio transmission devices 74, 76, 78 to execute a fast and simple realignment process to realign their reference oscillators. This is executed by the master radio transmission device 72 emitting a realignment command followed by a continuous reference signal. The slave radio transmission devices 74, 76, 76 execute the alignment process as described in the figures 3 to 6. The network 70 operates at a frequency of 2.4 GHz, uses a frequency hopping algorithm, a time slot based transfer protocol and therefore allows real time voice and data communications. Such a radio network 70 can be used to realign every single radio transmission device in a network. With radio transmission devices with an own power supply a remote alignment process can be executed. The alignment process may be executed without a visible connection between the calibrated reference frequency generator and the transmitter.

While particular embodiments of the present invention have been described and illustrated, it should be understood that the invention is limited only by the attached claims. Since modifications may be made by persons skilled in the art, the present application contemplates any and all modifications that fall within the spirit and scope of the invention disclosed and claimed herein.

**Claims**

1.  Radio transmission device (1) for receiving/transmitting of radio packets, comprising:

     a reception means (34) arranged to receive radio signals,
     a phase locked loop (14) designed to be locked to a multiple of a reference oscillator (8) frequency,
     a mixing means (4) having its inputs connected to said reception means (34) and said phase locked loop (14),
     an intermediate frequency filtering means (6) having its input connected to the output of said mixing means (4),
     a demodulation means (12) connected to the output of the intermediate frequency filtering means (6)
     and a base band processing means (20) connected to the output of the demodulation means (12),

     <u>characterised by</u>

     a branch off line connected between the reference oscillator (8) and the phase locked loop (14),
     a frequency dividing means (10), releaseably connected to said branch off line to divide the reference frequency of said reference oscillator (8),
     the output of said frequency dividing means (10) being connected with the input of said intermediate frequency filtering means (6) and
     said base band processing means (20) being connected to said reference oscillator (8).

2.  Radio transmission device for receiving/transmitting of radio packets, comprising:

     a reception means (34) connected to a mixing means (4) via a transmit/receive switch (32) and an amplifying means (30),
     said mixing means (4) being connected via a demodulation means (12) to a base band processing means (20), wherein said base band processing means (20) is connected via a modulation means (28) to a power amplifying means (42),

     <u>characterised in that</u>

     said modulation means (28) is releasably connected via a phase locked loop circuit (15) to said mixing means (4).

3.  Radio transmission device according to claim 2, further comprising:

     a phase locked loop (14) designed to be locked to a multiple of a reference oscillator (8) frequency,
     said mixing means (4) having its inputs connected to said amplifying means (30) and said phase locked loop (14),
     an intermediate frequency filtering means (6) operatively inserted between said mixing means (4) and said demodulation means (12),
     a branch off line connected between the reference oscillator (8) and the phase locked loop (14),
     a frequency dividing means (10), releasably connected to said branch off line to divide the reference frequency of said reference oscillator (8),
     the output of said frequency dividing means (10) being connected with the input of said intermediate frequency filtering means (6) and
     said base band processing means (20) being connected to said reference oscillator (8).

4.  Radio transmission device according to claim 1 or 3, wherein the output of said frequency dividing means (10) is connected with the input of said demodulation means (12).

5.  Radio transmission device according to one of the claims 1 to 4, wherein the base band processing means (20) comprises analog/digital converting means.

6. Radio transmission device according to one of the claims 1 to 5, further comprising an auxiliary amplifying means operationally inserted between the demodulation means (12) and the base band processing means (20).

7. Radio transmission device according to one of the preceding claims, further comprising a pre-calibrated reference oscillator.

8. Radio network (70) comprising radio transmission devices (72, 73, 74, 76) as claimed in one of the claims 1 to 7.

9. Method for aligning parameters in a radio transmission device according to one of the claims 1 to 8, comprising the steps of:

   - Supplying a fixed continuous wave signal to said radio transmission device;
   - Initiating a fast and simple alignment process in said radio transmission device in accordance with said continuous wave signal;
   - Terminating the fast and simple alignment process.

10. Method according to claim 9, further comprising the steps of:

   - Inhibiting a signal of said phase locked loop (14);
   - Dividing a signal of said reference oscillator (8);
   - Demodulating said divided reference oscillator signal;
   - Detecting said demodulated reference oscillator signal;
   - Saving said detected demodulated reference oscillator signal;
   - Inhibiting said divided reference oscillator signal;
   - Terminating the inhibition of said phase locked loop signal;
   - Mixing the phase locked loop signal with said fixed continuous wave signal;
   - Filtering said mixed signal;
   - Demodulating said filtered mixed signal;
   - Detecting said demodulated filtered mixed signal;
   - Comparing said demodulated mixed signal with said saved demodulated reference oscillator signal;
   - Varying a reference oscillator parameter until said demodulated mixed signal equals said demodulated reference oscillator signal.

11. Method according to claims 9, further comprising the steps of:

   - Applying a fixed modulated continuous wave signal;
   - Amplifying said fixed modulated continuous wave signal;
   - Mixing said fixed modulated continuous wave signal with said local oscillator signal;
   - Demodulating said first mixed signal;
   - Detecting said first demodulated signal;
   - Saving said first detected signal;
   - Applying said fixed continuous wave signal;
   - Amplifying said fixed continuous wave signal;
   - Modulating said local oscillator signal;
   - Mixing said fixed continuous wave signal with said modulated local oscillator signal;
   - Demodulating said second mixed signal;
   - Recalling said saved signal
   - Comparing said saved signal with said second demodulated mixed signal;
   - Varying a modulation means parameter until said second demodulated mixed signal equals said saved signal.

12. Method according to one of the claims 9 to 11, further comprising the step of:

   - Filtering said divided reference oscillator signal

13. Method according to claim 9 to 12 further comprising the step of:

- Digitising said demodulated signals.
- Digitising said demodulated mixed signal

14. Method according to one of claims 9 to 13, further comprising the step of:

- Amplifying the signals between demodulating and detecting the signal

15. Method according to one of the claims 9 to 14, further comprising at least one of the following steps of:

- Initiating a second alignment process in the radio transmission device;
- Repeating the alignment process.

# Fig. 1

```
┌──────────┐         58          ┌──────────┐
│    54    │ ──────────────────▶ │    56    │
└──────────┘                     └──────────┘
      ▲                                │
      │  60        ┌──────────┐        │  62
      └────────────│    52    │◀───────┘
                   └──────────┘
```

# Fig. 2

```
                        ～  modulated signal
        ┌──────────┐              ┌──────────┐
        │    64    │ ──────────▶  │    66    │
        └──────────┘              └──────────┘
              ▲                         ▲
              │  60   ┌──────────┐  62  │
              └───────│    52    │──────┘
                      └──────────┘
```

# Fig. 3

```
┌──────────┐         ┌──────────┐
│    2     │ ──────▶ │    54    │
└──────────┘         └──────────┘
```

Fig. 4

EP 1 215 822 A1

Fig. 5

# Fig. 6

modulated signal (2.4 GHz + 1MHz)

DUT

1MHz

| | | | |
|---|---|---|---|
| 2 | 34 | | |

32

30

4

12

20

unmodulated signal

~ modulated signal

15

no signal present

42

28

no signal present

44

# Fig. 7

unmodulated signal

DUT

1 MHz

2

34

32

30

4

12

20

~ modulated signal

15

no signal present

42

28

44

EP 1 215 822 A1

# Fig. 8

70

72

74

76

78

## EUROPEAN SEARCH REPORT

**European Patent Office**

**Application Number**

EP 00 12 7720

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 493 710 A (TAKAHARA YASUAKI ET AL) 20 February 1996 (1996-02-20) | 9,10, 12-15 | H04B1/40 H04L27/16 H03J7/06 H04B17/00 |
| Y | * abstract * * column 3, line 22 - column 10, line 60 * * column 17, line 32 - line 39 * * column 23, line 53 - column 24, line 16 * * column 31, line 5 - line 20 * * figure 1 * * figure 5 * * figure 9 * | 1,5,7,8 | |
| A | | 4,6 | |
| X | US 5 280 644 A (FROEHLING TIMOTHY P ET AL) 18 January 1994 (1994-01-18) | 9 | |
| Y | * abstract * * column 4, line 48 - column 6, line 54 * * column 7, line 56 - column 10, line 62 * * figure 1 * * figure 3 * | 1,5,7,8 | |
| A | | 4,6, 12-15 | **TECHNICAL FIELDS SEARCHED (Int.Cl.7)** |
| X | US 5 170 492 A (MOLLER PAUL J ET AL) 8 December 1992 (1992-12-08) | 9,13,14 | H04B H04L H03J |
| Y | * the whole document * | 1 | |
| A | | 4-8,12, 15 | |
| A | DE 36 26 792 A (SIEMENS AG) 11 February 1988 (1988-02-11) * the whole document * | 1,4-9, 12-15 | |
| Y | US 6 137 999 A (MCGINN MICHAEL ET AL) 24 October 2000 (2000-10-24) | 2,5-7 | |
| A | * the whole document * | 3,4,9,11 | |
| | -/-- | | |

The present search report has been drawn up for all claims

| Place of search | Date of completion of the search | Examiner |
|---|---|---|
| THE HAGUE | 27 September 2001 | Lindhardt, U |

EP 1 215 822 A1

**European Patent Office**

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

## EUROPEAN SEARCH REPORT

European Patent Office

Application Number

EP 00 12 7720

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y | US 5 507 015 A (KARCZEWSKI CASIMIR ET AL) 9 April 1996 (1996-04-09) | 2,5-7 | |
| A | * abstract * <br> * column 1, line 60 - column 3, line 47 * <br> * figure 1 * | 3,4,9,11 | |
| A | US 5 802 463 A (ZUCKERMAN LAWRENCE H) 1 September 1998 (1998-09-01) <br> * abstract * <br> * column 3, line 5 - column 4, line 28 * <br> * figure 1 * <br> * figure 2 * | 2-7,9,11 | |

TECHNICAL FIELDS SEARCHED (Int.Cl.7)

The present search report has been drawn up for all claims

| Place of search | Date of completion of the search | Examiner |
|---|---|---|
| THE HAGUE | 27 September 2001 | Lindhardt, U |

EPO FORM 1503 03 82 (P04C01)

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

European Patent
Office

**LACK OF UNITY OF INVENTION
SHEET B**

Application Number

EP 00 12 7720

The Search Division considers that the present European patent application does not comply with the requirements of unity of invention and relates to several inventions or groups of inventions, namely:

1. Claims: 1, 9, 10, 12 – 15 and 4 – 8 as dependent of claim 2

   Method and system comprising a reference oscillator being controlled by baseband processing means

2. Claims: 2, 3, 9, 11 and 4 – 8 as dependent of claim 2

   Method and system for using the receiver part of a transceiver for calibrating a modulation parameter of the transmitter part

## ANNEX TO THE EUROPEAN SEARCH REPORT
## ON EUROPEAN PATENT APPLICATION NO.

EP 00 12 7720

This annex lists the patent family members relating to the patent documents cited in the above-mentioned European search report.
The members are as contained in the European Patent Office EDP file on
The European Patent Office is in no way liable for these particulars which are merely given for the purpose of information.

27-09-2001

| Patent document cited in search report | | Publication date | Patent family member(s) | | Publication date |
|---|---|---|---|---|---|
| US 5493710 | A | 20-02-1996 | JP | 5037414 A | 12-02-1993 |
| | | | JP | 3184270 B2 | 09-07-2001 |
| | | | JP | 5167468 A | 02-07-1993 |
| US 5280644 | A | 18-01-1994 | BR | 9305938 A | 26-08-1997 |
| | | | CA | 2127366 A1 | 07-07-1994 |
| | | | GB | 2279520 A ,B | 04-01-1995 |
| | | | JP | 7504308 T | 11-05-1995 |
| | | | MX | 9307986 A1 | 31-08-1994 |
| | | | WO | 9415409 A1 | 07-07-1994 |
| US 5170492 | A | 08-12-1992 | AT | 179037 T | 15-04-1999 |
| | | | CA | 2034088 A1 | 23-07-1991 |
| | | | CA | 2034088 C | 17-05-1994 |
| | | | DE | 69131110 D1 | 20-05-1999 |
| | | | DE | 69131110 T2 | 11-11-1999 |
| | | | EP | 0439326 A2 | 31-07-1991 |
| | | | FI | 910267 A | 23-07-1991 |
| | | | NO | 178249 B | 06-11-1995 |
| | | | SG | 46267 A1 | 20-02-1998 |
| DE 3626792 | A | 11-02-1988 | DE | 3626792 A1 | 11-02-1988 |
| US 6137999 | A | 24-10-2000 | JP | 11251947 A | 17-09-1999 |
| US 5507015 | A | 09-04-1996 | CN | 1142292 A | 05-02-1997 |
| | | | WO | 9523458 A2 | 31-08-1995 |
| US 5802463 | A | 01-09-1998 | DE | 69701635 D1 | 11-05-2000 |
| | | | DE | 69701635 T2 | 16-11-2000 |
| | | | EP | 0920729 A1 | 09-06-1999 |
| | | | WO | 9808300 A1 | 26-02-1998 |

EPO FORM P0459

For more details about this annex : see Official Journal of the European Patent Office, No. 12/82